# EUROPEAN PATENT SPECIFICATION

(11) **EP 1 615 304 B1**
(45) Date of publication and mention of the grant of the patent: **12.12.2007**
(21) Application number: 05009510.8
(22) Date of filing: 29.04.2005
(51) Int. Cl.: H01S 5/042, H01S 5/022, H01S 5/026, G02B 6/42

(54) **Optical module with simplified electrical wiring desing**
Optisches Modul mit vereinfachtem elektrischem Verdrahtungsdesign
Module optique comportant un design simplifié des connexions électriques

(30) Priority: 06.07.2004 JP 2004199346
(43) Date of publication of application: 11.01.2006
(73) Proprietor: OpNext Japan, Inc., Yokohama-shi, Kanagawa 224-8567 (JP)
(72) Inventor: Matsushima, Naoki, Hitachi Ltd, Chiyoda-ku Tokyo 100-8220 (JP); Yoshimoto, Kenji, Hitachi Ltd, Chiyoda-ku Tokyo 100-8220 (JP); Sasaki, Hiroyasu, Hitachi Ltd, Chiyoda-ku Tokyo 100-8220 (JP); Okayasu, Masanobu, Hitachi Ltd, Chiyoda-ku Tokyo 100-8220 (JP); Takai, Toshiaki, Hitachi Ltd, Chiyoda-ku Tokyo 100-8220 (JP)
(74) Representative: Strehl Schübel-Hopf & Partner

(56) References cited:
- US-A- 5 530 714
- US-A1- 2002 141 709
- US-A1- 2003 165 303
- US-B1- 6 556 599
- US-B1- 6 632 029
- GATES J ET AL: "Hybrid integrated silicon optical bench planar lightguide circuits" ELECTRONIC COMPONENTS & TECHNOLOGY CONFERENCE, 1998. 48TH IEEE SEATTLE, WA, USA 25-28 MAY 1998, NEW YORK, NY, USA,IEEE, US, 25 May 1998 (1998-05-25), pages 551-559, XP010283728 ISBN: 0-7803-4526-6
- ISHITSUKA F ET AL: "A compact MU interface 2.5-Gb/s optical transmitter module with an embedded LD-driver IC" ELECTRONIC COMPONENTS & TECHNOLOGY CONFERENCE, 1998. 48TH IEEE SEATTLE, WA, USA 25-28 MAY 1998, NEW YORK, NY, USA,IEEE, US, 25 May 1998 (1998-05-25), pages 184-191, XP010283747 ISBN: 0-7803-4526-6

## Description

### BACKGROUND OF THE INVENTION

### 1. Field of the Invention

The present invention relates to an optical module, and more particularly, to a small optical module in which electrical wirings in a module package are simplified.

### 2. Description of the Related Art

As a demand of a marketplace in an optical communication system, there is miniaturization of size of an optical communication module. On the other hand, the optical communication module tends to be multi-functional and a plurality of wirings for electrically connecting various components to an outside of a package need to be provided. Accordingly, the number of leads in the module tends to be increased.

As a means for satisfying the above demand, there is a method of arranging leads included in the package of the optical communication module at a specific location. For example, if the leads are arranged at only one sidewall of a module package having a rectangular parallelepiped shape, the module can be arranged at an end of an optical transceiver when the optical module is mounted on the optical transceiver, thereby improving degree of freedom in arrangement of each component or degree of freedom in electrical wiring design. Also, since the leads exit from only one side thereof, it is advantageous in that the module size is reduced.

Japanese Patent Laid-Open No. 2003-060281 describes about a small light emitting element module capable of surface-mounting, and a method of manufacturing the same.

US-B1-6 632 029 discloses a method and apparatus for packaging high frequency components. The electrical connection between contact pins and the optical element is established by a base plate. The base plate is formed of an insulating layer sandwiched between two conductive layers and having a plurality of through-holes. Present claim 1 has been cast in the two-part form in view of this document.

In "Hybrid Integrated Silicon Optical Bench Planar Lightguide Circuits" Electronic Components and Technology Conference 1998, IEEE, pages 551 to 559, Gates et al. describe effective packaging of opto-electronic components in an optical module.

US 2003/165303 A1 discloses another example of an optical sub-assembly to be used in an opto-electronic module.

However, in a case of a package structure with leads formed at only one side, electrical wirings in the optical module package become complicated. Since optical and configurational restrictions have priorities in determining the arrangement of each functional component in the package, it is difficult to provide the electrical wirings in a simplified shape.

Particularly, in a case in which there are various electrodes at a side where leads do not exist with respect to an optical axis, it is necessary that they be connected by long bonding wires or a long relay board be formed. In this structure, the manufacturing process is complicated, and further there is a possibility that failure of the wirings is increased.

### SUMMARY OF THE INVENTION

In order to solve the above-mentioned problems, there is provided the optical module defined in claim 1. In an embodiment of the present invention, a functional component is mounted on a substrate(functioning as a pedestal) in which inner wirings are formed and electrodes connected to the wirings are formed at a side where the functional component is mounted. The functional component and the electrodes provided at one end of the wirings are connected to each other and one end of the leads and the electrodes provided at the other ends of the wirings are connected to each other.

According to the invention, an optical module, having leads formed at only one side, of which manufacturing process is simple and in which there is little possibility of a failure such as wire disconnection.

### BRIEF DESCRIPTION OF THE DRAWINGS

Preferred embodiments of the present invention will now be described in conjunction with the accompanying drawings, in which;
Fig. 1 is a side view and a plan view of a light emitting element module according to a first embodiment of the present invention;
Fig. 2 is a side view and a plan view of a substrate according to the first embodiment of the present invention;
Fig. 3 is a side view and a plan view of a light emitting element module according to a second embodiment of the present invention;
Fig. 4 is a side view and a plan view of a light emitting element module according to a third embodiment of the present invention;
Fig. 5 is a side view and a plan view of a light emitting element module according to a fourth embodiment of the present invention; and
Fig. 6 is a plan view of a transceiver module according to a fifth embodiment of the present invention.

### DESCRIPTION OF THE PREFERRED EMBODIMENTS

Hereinafter, embodiments of the present invention will be described with reference to the accompanying drawings.

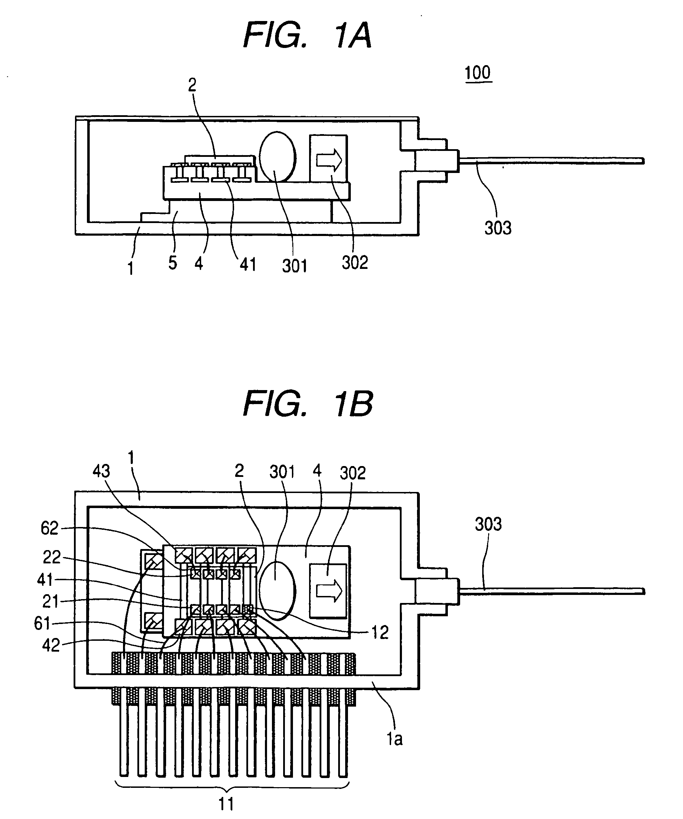

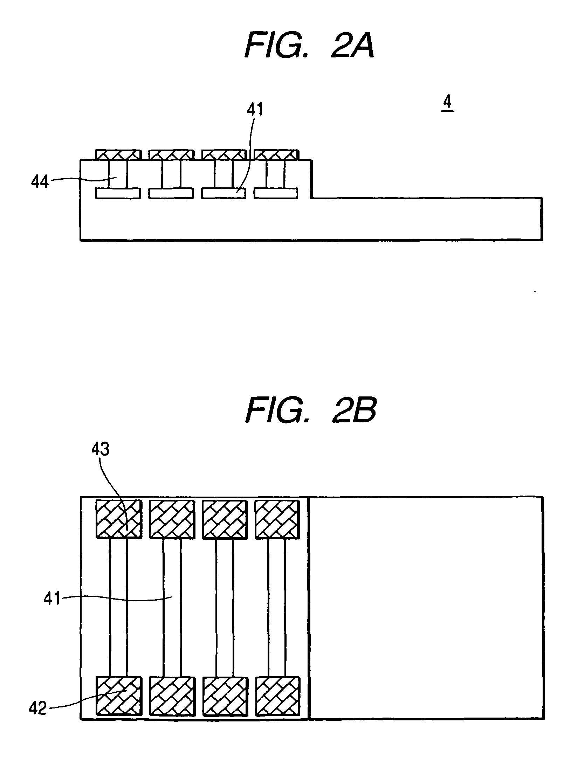

First, a light emitting element module according to a first embodiment of the present invention will be described with reference to Figs. 1 and 2. Here, Fig. 1 shows the light emitting element module according to the first embodiment of the present invention, and Fig. 1A is a side view thereof and Fig. 1B is a plan view thereof. Also, Fig. 2 show a substrate of the first embodiment, Fig. 2A is a side view thereof and Fig. 2B is a plan view thereof. Further, for simplicity of the figures, there are portions which are shown in the plan view but are not shown in the side view, and vice versa. This is the same in the other embodiments and what has been previously described will be omitted in the other embodiments.

In Fig. 1, a light emitting element 2 is an element for emitting a plurality of different wavelengths, which is called as a tunable laser diode. The light emitting element 2 has a plurality of waveguides (not shown) to emit light having a wide range of wavelength and two electrode groups 21 and 22 corresponding to each waveguide. The electrodes are formed at both sides with the waveguide therebetween. The plurality of waveguides is integrated into one waveguide (not shown) at a front emitting side in the light emitting element 2.

A light beam emitted from the light emitting element 2 is focused by a lens 301 located ahead thereof, passes through an isolator 302 for suppressing light reflected toward the light emitting element 2, and is coupled to an optical fiber 303 to be transmitted to an outside of the module.

A light emitting element module 100 is configured such that leads 11 for inputting electrical signals from an outside of a module package 1, having a rectangular parallelepiped shape, to an inside thereof and for outputting the electrical signals from the inside to the outside thereof penetrates a wall la which is one side of the package 1.

The light emitting element 2 is attached to a substrate 4 by soldering. Front and rear surfaces of the substrate 4 are formed with metallization layers, respectively (not shown). By using the metallization layers, the substrate 4 is mounted on a thermo-cooler 5 by the soldering connection and the thermo-cooler 5 is fixed to a bottom portion of the package 1 by soldering. Here, composition of the soldering (that is, melting point) is adequately selected by an order of the connection. The role of the thermo-cooler 5 is to cool the light emitting element 2 in which heat is generated due to the light emission and to control an oscillating wavelength by varying a temperature of the light emitting element 2.

In other words, the substrate 4 mounted with the light emitting element 2 serves as a heat transfer path between the light emitting element 2 and the thermo-cooler 5. Accordingly, it is preferable that a member having a low thermal resistance is used as the substrate 4 in order to efficiently emit the heat from the light emitting element 2. In the present embodiment, a ceramic substrate mainly composed of AlN (aluminum nitride), which is an insulating material having a low thermal resistance, is used. The substrate 4 shown in Fig. 2 includes electrical wirings 41 in which tungsten is used as a wiring material. Each electrode of an electrode group 42 is electrically connected to the corresponding electrode of an electrode group 43 through a via(also described as a via hole) 44 just below the electrode, an inner electrical wiring 41, and a via44 just below the electrode of the electrode group 43. Also, the substrate 4 is provided with a step to match an optical axis of the light emitting element 2, the lens 301 and the isolator 302. This step is formed by laminating a ceramic sheet. Accordingly, if wirings are formed on the ceramic sheet, the wirings 41 can be formed only by adding a process of embedding the via in a process of manufacturing the substrate 4.

Referring back to Fig. 1, by using the substrate 4, the electrode group 21 at a lead side of the light emitting element 2 can be directly wire-bonded to leads 11 and the electrode group 22 at a non-lead side (a side where leads do not exit with respect to the optical axis) of the light emitting element 2 can be wire-bonded to the very near electrode group 43 of the substrate 4. Since the electrode group 22 at the non-lead side of the light emitting element 2 is connected to the electrode group 42 of the substrate 4 closest to the leads 11 through the inner electrical wirings 41 of the substrate 4, the electrode group 42 is wire-bonded to the leads 11. Thereby, electrical connections can be made at a concentration portion of the bonding wires, without using long bonding wires. In addition, since the substrate for heat emission, which has been conventionally needed, can also perform a function of the electrical wirings, the number of components is not increased.

By wire-bonding a thermistor 12 formed on the light emitting element 2, terminals of the thermo-cooler 5 and the leads 11, the electrical wirings are completed. Here, it has been confirmed that, although bonding wires between the terminals of the thermo-cooler 5 and the leads 11 are long, there is no problem because interference with the other wires is little.

The light emitting element module 100 of the present invention is mounted with the light emitting element 2 having a plurality of the waveguides to correspond to a wide range of wavelength. Since the plurality of waveguides is provided with wirings, a waveguide can be selected from the outside to vary the wavelength in a wide range. Also, even by using only one waveguide, the wavelength can be varied in a narrow range by the thermistor 12, the thermo-cooler 5 and an external controlling circuit. Accordingly, the light emitting element module 100 of the present invention can widely vary the wavelength with high precision.

According to the present invention, a small light emitting element module, in which leads exit from only one side of the package, can be obtained.

In addition, as a material of the substrate 4, materials other than AlN may be used, but a material having a low thermal resistance is preferably used. As a suitable material substituting the AlN, there is SiC (silicon carbide), Si (silicon) or alumina. Also, with respect to an inner wiring material, materials other than Tungsten may be used if it does not have an extremely high electrical resistance.

Moreover, with respect to an optical structure, structures other than that of the embodiment may be used. For example, plural lenses may be used, or a light emitting element may be directly coupled to an optical fiber without using the lens. Further, an isolator may not be used if an effect due to reflected light can be avoided. In the present invention, a Peltier element is used as the thermo-cooler. The Peltier element becomes a thermo-heater in accordance with a direction of a flowing current, and is controlled to perform heating if a surrounding temperature is extremely low.

In the present embodiment, as a case of the light emitting element module, a metal wall type light emitting element module, in which leads pass through a hole formed in a side of a metal frame and which is hermetically sealed by glass, is used. However, the case is not limited to the metal wall type. For example, a field through type light emitting element module, in which a ceramic substrate formed with an electrical wiring is bonded to a metal frame, may be used. In this case, wirings formed on the ceramic substrate are leads. Modification of the above-mentioned embodiment is the same in the other embodiments.

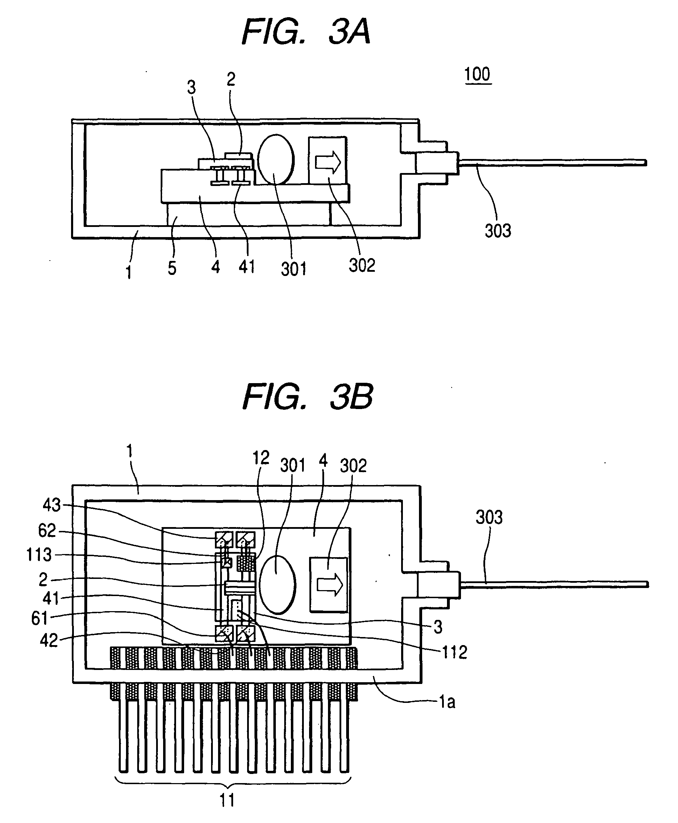

Next, the light emitting element module according to a second embodiment of the present invention will be described with reference to Fig. 3. Here, Fig. 3 shows the light emitting element module according to the second embodiment of the present invention, and Fig. 3A is a side view thereof and Fig. 3B is a plan view thereof.

In Fig. 3, the light emitting element 2 is attached to the substrate 4 through a sub-assembly substrate 3 by soldering. The substrate 4 is mounted on the thermo-cooler 5 by the soldering connection and the thermo-cooler 5 is fixed to a bottom portion of the package 1 by soldering.

The light emitting element module 100 of the second embodiment is configured to have leads 11 provided at one side la of the module package 1. The light emitting element 2 of the present embodiment is a laser diode with a single wavelength. The light emitting element 2 is mounted on the sub-assembly substrate 3 to evaluate light emitting characteristic of the light emitting element 2 before it is mounted on the substrate 4. There is a yield as an evaluating test item, and when there is a problem in the light emitting element 2, the light emitting element 2 must be separated form the sub-assembly substrate 3. On this account, the sub-assembly substrate 3 preferably has a low thermal resistance. Also, in consideration of a case in which the light emitting element 2 can not be separated from the sub-assembly substrate 3, the sub-assembly substrate 3 is preferably low in price. Further, since the light emitting element 2 is mounted thereon, a thermal expansion coefficient of the sub-assembly substrate 3 should be close to that of the semiconductor. Accordingly, in the present embodiment, AlN is used as a material of the sub-assembly substrate 3.

The sub-assembly substrate 3 ismounted with a thermistor 12 for monitoring a temperature of the light emitting element 2. Furthermore, electrical wirings 112 for supplying electrical signals to the light emitting element 2 are provided. In order to efficiently arrange these components on the sub-assembly substrate 3, it is preferable that they are symmetrically provided with respect to an optical axis of the light emitting element 2. In the present embodiment, the thermistor 12 is arranged at a non-lead side.

As the substrate 4, similarly to the first embodiment, a member mainly composed of AlN is used in order to efficiently emit the heat from the light emitting element 2. Electrical wirings 41, in which Tungsten is used as a wiring material, are provided in the substrate 4. Electrodes of the electrode group 42 at a lead side and electrodes of the electrode group 43 at a non-lead side in the substrate 4 are electrically connected to each other through the electrical wirings 41 formed in the substrate 4. The leads 11 and the electrode group 42 are electrically connected to each other by bonding wires 61, and the electrode group 43 at a non-lead side of the substrate 4, the electrode 113 for the thermistor 12 and the thermistor 12 are connected to one another by bonding wires 62. Thereby, the electrode 113 for the thermistor 12 and the leads 11 of the package 1 can be electrically connected to each other.

According to the present embodiment, electrical connections can be made without employing a complicate form, such as using long bonding wires. In addition, since the substrate 4 for heat emission also performs a function of the electrical wirings, the number of components is not increased. Accordingly, a small light emitting element module, in which leads exit from only one side of the package, can be obtained.

Furthermore, although a component, in which electrical connections are made by using the inner wirings 41, is used as the thermistor 12, others may be used. For example, inner wirings may be used in the electrical wirings for supplying a current to the light emitting element 2. Also, although an inner layer may be provided in the sub-assembly substrate 3, it makes it difficult to separate the light emitting element 2.

Moreover, a material of the sub-assembly substrate 3 is not limited to AlN. Specifically, SiC, Si (silicon) or alumina may be used.

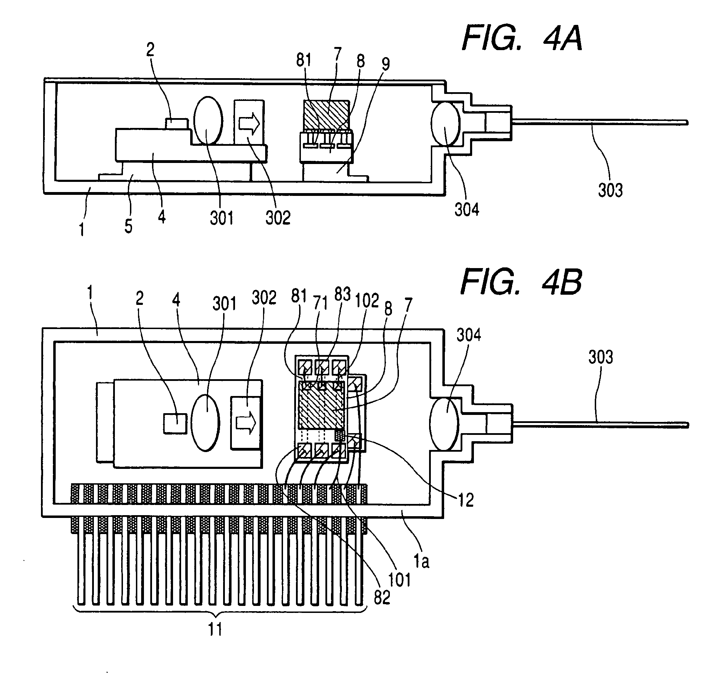

Next, the light emitting element module according to a third embodiment of the present invention will be described with reference to Fig. 4. Here, Fig. 4 shows the light emitting element module according to the third embodiment of the present invention, and Fig. 4A is a side view thereof and Fig. 4B is a plan view thereof. Further, as mentioned above, wiring at a vicinity of the light emitting element is not shown.

The light emitting element module 100 shown in Fig. 4 includes a light emitting element 2 and a wavelength locker 7. The wavelength locker 7 consists of two photodiodes and an etalon filter, and it is a component for monitoring a light intensity before and after the light emitted from the light emitting element 2 transmits the etalon filter to thereby stabilize a wavelength. A light beam emitted from the light emitting element 2 becomes collimated light by a lens 301 located ahead thereof and is incident on the wavelength locker 7 through an isolator 302. The light beam transmitting through the wavelength locker 7 is focused by a lens 304 and is coupled to an optical fiber 303 to be delivered to an outside of the module.

The light emitting element module 100 is configured such that leads 11 are formed at a sidewall la of the module package 1. An electrode group 71 of the photodiode constituting the wavelength locker 7 is arranged at a side (at a non-lead side) distant from the sidewall 1a through which the leads 11 penetrate. The wavelength locker 7 is attached to a substrate 8 by soldering, and the substrate 8 is mounted on a thermo-cooler 9 by soldering connection. Further, the thermo-cooler 9 is fixed to a bottom portion of the package 1 by soldering. Here, the thermo-cooler 9 controls a temperature of the wavelength locker 7 and a monitoring wavelength. An external controlling device (not shown) controls the temperature of the thermo-cooler 5 mounted with the light emitting element 2 so that the light intensity ratios before and after transmitting the etalon filter of the wavelength locker 7 can be constant.

The substrate 8 has inner electrical wirings 81 therein. In the present embodiment, alumina is used as an insulating material of the substrate 8 and tungsten is used as a material of the inner wirings. But, similarly to the first embodiment, other members may be used. Electrodes 82 at a lead side of the substrate 8 are electrically connected to electrodes 43 at a non-lead side through the electrical wirings 81 formed in the substrate 4. The leads 11 and the electrodes 82 are electrically connected to each other by boding wires 101, and electrodes 83 and electrodes 71 of the photodiode constituting the wavelength locker 7 are connected to each other by bonding wires 102. Thereby, the electrodes 71 of the wavelength locker 7 and the leads 11 of the package 1 can be electrically connected to each other, and thus the electrical wirings can exit to an outside of the module package 1.

In this specification, a light emitting element and a wavelength locker are called as functional components. Also, the functional component is not limited thereto, but it is a general term of components which have electric terminals and are placed on an optical axis. The functional component includes a light receiving element, and an optical modulator described below.

According to the present embodiment, electrical connections can be made without employing a complicate form, such as using long bonding wires. In addition, since the substrate for heat coupling with the thermo-cooler also performs a function of the electrical wirings, the number of components is not increased. Accordingly, a small light emitting element module, in which leads exit from only one side of the package, can be obtained.

With respect to an optical structure, structures other than the structure shown in the third embodiment may be used. For example, a structure in which convergence light is allowed to pass the wavelength locker 7 without using the lens 304 may be used. Furthermore, an isolator may not be used if an effect due to reflected light can be avoided. Also, although the wavelength locker 7 according to forward light of the light emitting element 2 is illustrated in the third embodiment, a wavelength locker according to backward light thereof may be used.

In the present embodiment, the Peltier element is used as a thermo-cooler. The Peltier element becomes a thermo-heater in accordance with a direction of a flowing current, and is controlled to perform heating in accordance with a wavelength to be monitored.

In addition, although the light emitting element and the wavelength locker are accommodated in the same case in the present embodiment, a structure in which they are accommodated in different cases and are coupled to each other using an optical fiber may be considered. In this case, a module accommodating the wavelength locker is called as a wavelength locker module. The light emitting element module and the wavelength locker module are generally called optical modules. Further, the optical module includes a light receiving element module and an optical modulator module, but it is not limited thereto.

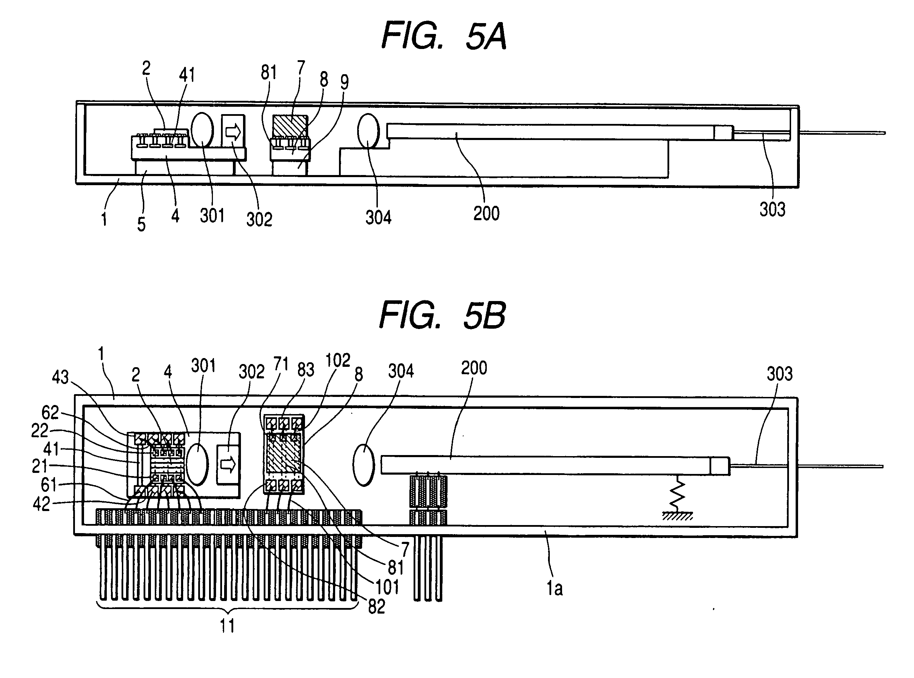

Next, the light emitting element module according to a fourth embodiment of the present invention will be described with reference to Fig. 5. Here, Fig. 5 shows the light emitting element module according to the fourth embodiment of the present invention, and Fig. 5A is a side view thereof and Fig. 5B is a plan view thereof.

Fig. 5 shows a light module 100 comprising a light emitting element 2, a wavelength locker 7 and a Mach-Zehnder modulator 200 in a module package 1. Light emitted from the light emitting element 2 becomes collimated light by a lens 301 and is incident on the wavelength locker 7 through an isolator 302. Light beam transmitting through the wavelength locker 7 is focused by a lens 304 and is incident on the Mach-Zehnder modulator 200. The light modulated by the Mach-Zehnder modulator 200 is transmitted to an outside of the module through an optical fiber 303.

The light emitting element 2 is a tunable light source and comprises a plurality of waveguides so as to emit light having a wide range of wavelength and a plurality of electrodes 21 and 22 corresponding to each waveguide. The electrodes are formed at both sides of the waveguide. The waveguide locker 7 monitors a wavelength of the light emitted from the light emitting element 2 before and after transmitting an etalon filter, by using two photodiodes. The Mach-Zehnder modulator 200 has a function for modulating continuous light emitted form the light emitting element 2 into signal light, and the length of an optical axis thereof is several tens mm.

The module 100 is configured such that leads 11 for inputting electrical signals from an outside to an inside of the package 1 and for outputting the electrical signals from the inside to the outside are provided in a sidewall 1a.

A mounting structure of the light emitting element 2 is that it is attached to the substrate 4 by soldering, similarly to the first embodiment. The substrate 4 is mounted on the thermo-cooler 5 by soldering connection and the thermo-cooler 5 is fixed to a bottom portion of the package 1 by soldering. Further, the light emitting element 2 may be mounted on the substrate 4 through the sub-assembly substrate, similarly to the second embodiment.

A ceramic substrate mainly composed of AlN (aluminum nitride) is used as a material of the substrate 4, similarly to the first embodiment. The substrate 4 has inner electrical wirings 41 therein. As a material of the wiring, tungsten is used. Electrode group 42 at a lead side and electrode group 43 at a non-lead side of the package 1 of the substrate 4 are electrically connected to each other through the electrical wirings 41 formed at the inside in the substrate 4.

Thereby, the leads 11 penetrating through a sidewall of the package and the electrode group 42 at the lead side are electrically connected to each other by bonding wires 61, and the electrode group 43 at a non-lead side and the electrode group 22 at a non-lead side of the light emitting element 2 are connected to each other by bonding wires 62. In this way, the electrodes 22 of the light emitting element 2 and the leads 11 of the package 1 can be electrically connected to each other, and thus the electrical wirings can exit to an outside of the module package 1. The electrode group 21 of the light emitting element 2 at a lead side is directly connected to the leads 11 by wire bonding.

An electrode group 71 of the photodiode of the wavelength locker 7 is arranged at the non-lead side. The wavelength locker 7 is attached to the substrate 8 by soldering. The substrate 8 is mounted on the thermo-cooler 9 by soldering connection and the thermo-cooler 9 is fixed to the bottom portion of the package 1 by soldering.

The substrate 8 has inner electrical wirings 81 therein. In the present embodiment, alumina (aluminum oxide) is used as an insulating material of the substrate 8 and tungsten is used as a material of the inner wirings. An electrode group 82 at a lead side of the substrate 8 is electrically connected to an electrode group 43 at a non-lead side through electrical wirings 81 formed in the substrate 4. The leads 11 penetrating through a sidewall of the package and the electrode group 82 at the lead side are electrically connected to each other by bonding wires 101, and an electrode group 83 at the non-lead side of the substrate 8 and the electrode group 71 of the photodiode constituting the wavelength locker 7 are connected to each other by bonding wires 102. Thereby, the electrode group 71 of the wavelength locker 7 and the leads 11 of the package 1 can be electrically connected to each other, and thus the electrical wirings can exit to an outside of the module package 1.

The Mach-Zehnder modulator 200 is made of LiNbO₃ crystal and can modulate continuous light, having a wide range of wavelength, emitted from the tunable light source (the light emitting element 2) into an optical signal having a transmission rate of 10 Gbits/s, by using an electrical signal having a transmission rate of 10 Gbits/s from an outside (not shown).

In the present embodiment, electrical connections can be made without employing a complicate form, such as using long bonding wires. In addition, since the substrate for heat emission also performs a function of the electrical wiring, the number of the components is not increased. Accordingly, a small light emitting element module, in which leads exit from only one side of the package, can be obtained.

Furthermore, although the inner wirings are provided at both of the light emitting element 2 and the wavelength locker 7 in the present embodiment, a structure in which the inner wirings are provided at only one of them may be employed. Also, with respect to an optical structure, methods other than the embodiment may be used. For example, a method for coupling convergence light from the lens 304 to an optical fiber to transmit the light by directly connecting the optical fiber to the Mach-Zehnder modulator may be used.

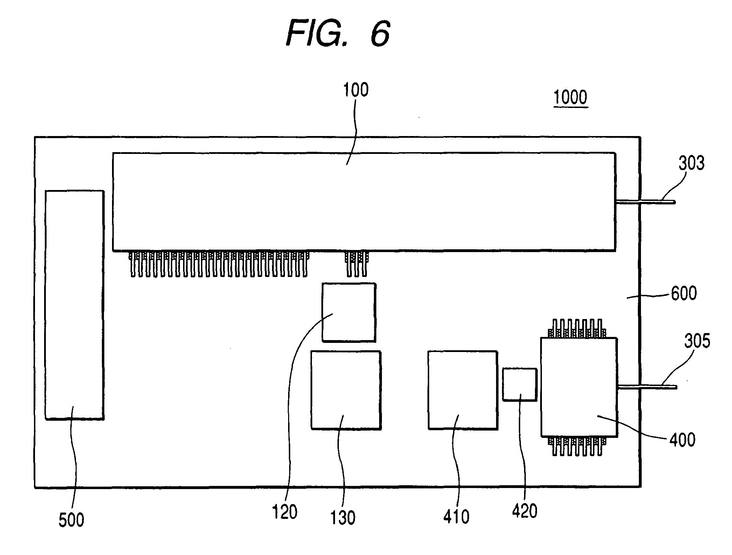

Next, a transceiver module according to a fifth embodiment of the present invention will be described with reference to Fig. 6. Here, Fig. 6 is a plan view of the transceiver module according to the fifth embodiment of the present invention.

An optical transceiver 1000 shown in Fig. 6 consists of a light emitting element module 100 illustrated in the fourth embodiment, a light receiving element module 400 and peripheral circuits. Four electrical signals, each having a transmission rate of 2.4 Gbits/s, input from a connector 500 are multiplexed to a signal having a transmission rate of 10 Gbits/s at a multiplexing IC 130, then is transmitted to the light emitting element module 100 through a driving IC 120 for outputting an modulated signal to the Mach-Zehnder modulator 200, and then an optical signal having a transmission rate of 10 Gbits/s is transmitted to the optical fiber 303.

An optical signal, having a transmission rate of 10 Gbits/s, transmitted from the optical fiber 305 is converted into an electrical signal in a light receiving element module 400, then passes through an amplifying IC 420, and then is divided into four signals, each having a transmission rate of 2.4 Gbits/s, in a demultiplexing IC 410 to be transmitted from the connector 500.

In the optical transceiver of the present invention, since the light emitting element module 100, in which leads are arranged at only one side of the package, is used, the light emitting element module 100 can be positioned at the end of the substrate 600 and thus the optical transceiver can be miniaturized.

Moreover, the package of the light receiving element, in which the leads are positioned at only one side thereof, may be used. Further, a light transmitter module, in which the light emitting element and the peripheral circuits are mounted on the substrate, may be used. Similarly, a light receiver module, in which the light receiving element having the leads provided at only one side of the package and the peripheral circuits are mounted on the substrate, may be used.

Here, the optical transceiver, the light transmitter module and the light receiver module all are optical modules.

## Claims

1. An optical module comprising:
a substantially rectangular parallelepiped case (1) having leads (11) for inputting and outputting electrical signals, wherein said leads penetrate one sidewall (1a) of the case only;
a light emitting element (2) accommodated in the case (1) and emitting light along an optical axis parallel to said one sidewall (1a); and
a substrate (4) connected to said light emitting element (2) and formed with wirings (41) therein each comprising a pair of second electrodes (42, 43) provided at both sides of an optical axis of the light emitting element (2),
**characterised in that**
said light emitting element (2) has at least one waveguide, each waveguide comprising a pair of first electrodes (21, 22) provided at both sides of the optical axis of the light emitting element, and
for each of the waveguides, the first electrodes (21) at the side of the optical axis closer to the one sidewall (1a) are directly wire-bonded to a first group of the leads (11), while the first electrodes (22) at the side of the optical axis closer to the other sidewall are wire-bonded to the second electrodes (43) at the side of the optical axis closer to the other sidewall which are electrically connected through the wirings (41) to the second electrodes (42) at the side of the optical axis closer to the one sidewall (1a) which are in turn connected to a second group of the leads (11) via bonding wires (61).

2. The module of claim 1, further comprising an optical fiber (303) for outputting optical signals.

3. The module of claim 2, further comprising within said case (1):
a wavelength locker (7) for monitoring an optical output of said light emitting element (2); and
a modulator (200) arranged between said wavelength locker (7) and said optical fiber (303) for modulating light passing through said wavelength locker,
wherein electrodes (71) of the wavelength locker (7) are electrically connected to respective ones of the leads (11) different from those electrically connected to the first and second electrodes (21, 42).

4. The module of any preceding claim, wherein said light emitting element (2) comprises a plurality of waveguides and is a tunable laser diode, i.e. a diode whose wavelength can be varied.

5. The module of any preceding claim, further comprising a thermo-cooler (5), which is preferably a Peltier element, interposed between a bottom portion of said case (1) and said substrate (4), wherein
the substrate (4) is adapted to transfer heat between said thermo-cooler (5) and said light emitting element (2), and
terminals of the thermo-cooler (5) are wire-bonded to respective ones of the leads (11) different from those electrically connected to the first and second electrodes (21, 42).

6. The module of any preceding claim, wherein the light emitting element (2) has a plurality of waveguides which are integrated into one waveguide at a front emitting end of the light emitting element.

7. The module of any preceding claim, wherein
the case (1) comprises a metal frame including the pair of sidewalls,
the leads (11) are provided as wirings formed on a ceramic substrate which is bonded to the one of sidewalls (1 a), and
the wirings are arranged along the optical axis of the light emitting element.

8. The module of claim 7 when depending on claim 2, wherein
the metal frame has another wall other than the pair of sidewalls, and
the optical fiber (303) is fixed to the another wall of the metal frame.

9. The module of claim 7 or 8, wherein the wirings are arranged on the ceramic substrate along the optical axis of the light emitting element (2) in an order corresponding to the arrangement of the first electrodes (21, 22).

10. An optical module comprising:
a light emitting element module (100) according to the module of any preceding claim; and
a light receiving element module (400).

## Patentansprüche

1. Optisches Modul mit
einem im wesentlichen rechtwinkligen Parallelepiped-Gehäuse (1), das Leitungen (11) zum Ein- und Ausgeben elektrischer Signale aufweist, wobei die Leitungen nur eine Seitenwand (1a) des Gehäuses durchdringen,
einem lichtemittierenden Element (2), das in dem Gehäuse (1) aufgenommen ist und Licht längs einer zu der einen Seitenwand (1a) parallelen optischen Achse emittiert, und
einem Substrat (4), das an das lichtemittierende Element (2) angeschlossen und mit Verdrahtungen (41) ausgebildet ist, die jeweils ein Paar zweiter Elektroden (42, 43) aufweisen, die auf beiden Seiten einer optischen Achse des lichtemittierenden Elements (2) angeordnet sind,
**dadurch gekennzeichnet, daß**
das lichtemittierende Element (2) wenigstens einen Wellenleiter aufweist, der ein Paar erster Elektroden (21, 22) aufweist, die auf beiden Seiten der optischen Achse des lichtemittierenden Elements angeordnet sind, und
für jeden Wellenleiter die ersten Elektroden (21) an der Seite der optischen Achse, die näher an der einen Seitenwand (1a) liegt, direkt mit einer ersten Gruppe der Leitungen (11) drahtverbunden sind, während die ersten Elektroden (22) an der Seite der optischen Achse, die näher an der anderen Seitenwand liegt, mit den zweiten Elektroden (43) an der Seite der optischen Achse drahtverbunden sind, die näher an der anderen Seitenwand liegt, wobei die zweiten Elektroden durch die Verdrahtungen (41) elektrisch an die zweiten Elektroden (42) an der Seite der optischen Achse angeschlossen sind, die näher an der einen Seitenwand (1a) liegt, die wiederum über Bonddrähte (61) an eine zweite Gruppe der Leitungen (11) angeschlossen sind.

2. Modul nach Anspruch 1, ferner mit einer optischen Faser (303) zum Ausgeben optischer Signale.

3. Modul nach Anspruch 2, das innerhalb des Gehäuses (1) ferner aufweist:
einen Wavelength-Locker (7) zum Überwachen eines optischen Ausgabesignals des lichtemittierenden Elements (2), und
einen Modulator (200), der zwischen dem Wavelength-Locker (7) und der optischen Faser (303) angeordnet ist, um durch den Wavelength-Locker hindurchtretendes Licht zu modulieren,
wobei Elektroden (71) des Wavelength-Lockers (7) elektrisch an entsprechende Leitungen (11) angeschlossen sind, die sich von denen unterscheiden, die elektrisch an die ersten und die zweiten Elektroden (21, 42) angeschlossen sind.

4. Modul nach einem der vorstehenden Ansprüche, wobei das lichtemittierende Element (2) mehrere Wellenleiter aufweist und in einer abstimmbaren Laserdiode besteht, d.h. einer Diode, deren Wellenlänge variierbar ist.

5. Modul nach einem der vorstehenden Ansprüche, ferner mit einem Thermokühlelement (5), das vorzugsweise in einem Peltier-Element besteht, und das zwischen einem Bodenabschnitt des Gehäuses (1) und dem Substrat (4) eingeschoben ist, wobei
das Substrat dazu ausgelegt ist, Wärme zwischen dem Thermokühlelement (5) und dem lichtemittierenden Element (2) zu transferieren, und
Anschlüsse des Thermokühlelements (5) mit entsprechenden Leitungen (11) drahtverbunden sind, die von denen verschieden sind, die elektrisch an die ersten und die zweiten Elektroden (21, 42) angeschlossen sind.

6. Modul nach einem der vorstehenden Ansprüche, wobei das lichtemittierende Element (2) mehrere Wellenleiter aufweist, die in einem Wellenleiter an einem vorderen Emissionsende des lichtemittierenden Elements integriert sind.

7. Modul nach einem der vorstehenden Ansprüche, wobei
das Gehäuse (1) einen Metallrahmen mit mehreren Seitenwandpaaren aufweist,
die Leitungen (11) als Verdrahtungen vorgesehen sind, die auf einem Keramiksubstrat gebildet sind, das mit der einen Seitenwand (1a) verbunden ist, und
die Verdrahtungen längs der optischen Achse des lichtemittierenden Elements angeordnet sind.

8. Modul nach Anspruch 7, wenn abhängig von Anspruch 2, wobei
der Metallrahmen eine weitere, von dem Paar von Seitenwänden verschiedene Wand aufweist, und
die optische Faser (303) an der weiteren Wand des Metallrahmens befestigt ist.

9. Modul nach Anspruch 7 oder 8, wobei die Verdrahtungen auf dem Keramiksubstrat längs der optischen Achse des lichtemittierenden Elements (2) in einer der Anordnung der ersten Elektroden (21, 22) entsprechenden Ordnung angeordnet sind.

10. Optisches Modul mit
einem Lichtemissionselement-Modul (100) gemäß dem Modul nach einem der vorstehenden Ansprüche, und
einem Lichtempfangselement-Modul (400).

## Revendications

1. Module optique comportant :
un boîtier sensiblement rectangulaire parallélépipède (1) présentant des broches (11) pour entrer et délivrer en sortie des signaux électriques, lesdites broches pénétrant dans une paroi latérale (1a) du boitier uniquement ;
un élément émetteur de lumière (2) reçu dans le boîtier (1) et émettant de la lumière le long d'un axe optique parallèle à ladite une paroi latérale ; et
un substrat (4) connecté audit élément émetteur de lumière (2) et formé avec des conducteurs (41) à l'intérieur, comportant chacune une paire de secondes électrodes (42, 43) réalisées des deux côtés d'un axe optique de l'élément émetteur de lumière (2),
**caractérisé en ce que**
ledit élément émetteur de lumière (2) a au moins un guide d'ondes, chaque guide d'ondes comportant une paire de premières électrodes (21, 22) réalisées des deux côtés de l'axe optique de l'élément émetteur de lumière, et
pour chacun des guides d'ondes, les premières électrodes (21) sur le côté de l'axe optique le plus proche de ladite une paroi latérale (1a) sont directement soudées à un premier groupe des broches (11), alors que les premières électrodes (22) sur le côté de l'axe optique le plus proche de l'autre paroi latérale sont soudées aux secondes électrodes, (43) sur le côté de l'axe optique le plus proche de l'autre paroi latérale, qui sont électriquement connectées par les conducteurs (41) aux secondes électrodes (42) sur le côté de l'axe optique le plus proche de ladite une paroi latérale (la), qui elles-mêmes sont connectées à un second groupe des broches (11) par l'intermédiaire de fils de liaison (61).

2. Module selon la revendication 1, comportant en outre une fibre optique (303) en vue de délivrer la sortie des signaux optiques.

3. Module selon la revendication 2, comportant en outre dans ledit boîtier (1) :
verrouilleur de longueur d'onde (7) pour contrôler une sortie optique dudit élément émetteur de lumière (2) ; et
un modulateur (200) agencé entre ledit verrouilleur de longueur d'onde (7) et ladite fibre optique (303) pour moduler la lumière passant à travers ledit verrouilleur de longueur d'onde,
dans lequel des électrodes (71) du verrouilleur de longueur d'onde (7) sont électriquement connectées à des broches respectives (11) différentes de celles électriquement connectées aux premières et secondes électrodes (21, 42).

4. Module selon l'une quelconque des revendications précédentes, dans lequel ledit élément émetteur de lumière (2) comporte une pluralité de guides d'ondes et est une diode laser accordable, c'est-à-dire, une diode dont la longueur d'onde peut être modifiée.

5. Module selon l'une quelconque des revendications précédentes, comportant en outre un refroidisseur thermique (5), qui est de préférence un élément Peltier, interposé entre une partie inférieure dudit boîtier (1) et ledit substrat (4), dans lequel
le substrat (4) est adapté pour transférer de la chaleur entre ledit refroidisseur thermique (5) et ledit élément émetteur de lumière (2), et
des bornes du refroidisseur thermique (5) sont soudées à des broches respectives (11) différentes de celles électriquement connectées aux premières et secondes électrodes (21, 42).

6. Module selon l'une quelconque des revendications précédentes, dans lequel l'élément émetteur de lumière (2) a une pluralité de guides d'ondes qui sont intégrées dans un guide d'ondes à une extrémité d'émission frontale de l'élément émetteur de lumière.

7. Module selon l'une quelconque des revendications précédentes, dans lequel
le boîtier (1) comporte un cadre métallique incluant la paire de parois latérales,
les broches (11) sont réalisées en tant que conducteurs formés sur un substrat en céramique qui est soudé à l'une des parois latérales (la), et
les conducteurs sont agencés le long de l'axe optique de l'élément électroluminescent.

8. Module selon la revendication 7 lorsqu'elle est dépendante de la revendication 2, dans lequel
le cadre métallique présente une autre paroi distincte de la paire de parois latérales, et la fibre optique (303) est fixée à l'autre paroi du cadre métallique.

9. Module selon la revendication 7 ou 8, dans lequel les conducteurs sont agencés sur le substrat en céramique le long de l'axe optique de l'élément émetteur de lumière (2) dans un ordre correspondant à l'agencement des premières électrodes (21, 22).

10. Module optique comportant :
un module d'élément émetteur de lumière (100) conforme au module de l'une quelconque des revendications précédentes ; et
un module d'élément récepteur de lumière (400).
